# EUROPEAN PATENT APPLICATION

(11) **EP 2 555 593 A1**
(43) Date of publication of application: **06.02.2013**
(21) Application number: 11762712.5
(22) Date of filing: 25.03.2011
(51) Int. Cl.: H05B 33/10, H01L 51/50, H05B 33/12, H05B 33/22

(54) **METHOD OF PRODUCING SUBSTRATE FOR LIGHT-EMITTING DEVICE**

(30) Priority: 31.03.2010 JP 2010081667
(71) Applicant: Sumitomo Chemical Company Limited, Tokyo 104-8260 (JP)
(72) Inventor: KAJITANI, Masaru, Niihama-shi Ehime 792-0025 (JP)
(74) Representative: Jackson, Martin Peter
(86) International application number: PCT/JP2011/057391
(87) International publication number: WO 2011/122481

(57) **Abstract**

An object of the present invention is to provide a method for manufacturing a substrate for a light-emitting device, by which method a partition wall that has a first partition wall member and a second partition wall member can be formed in fewer steps.

The method for manufacturing a substrate for a light-emitting device of the present invention includes: forming a first thin film for forming the first partition wall member, on the supporting substrate; forming a second thin film for forming the second partition wall member, on the first thin film by using a photosensitive resin; removing a residual portion of the second thin film that is other than a portion overlapping with the first partition wall member to be formed, as viewed from a thickness direction of the supporting substrate, by using a photolithography method; removing a residual portion of the first thin film that is other than a portion covered with the second thin film by using etching, thereby forming the first partition wall member; and removing a surface part of the second thin film by etching, thereby forming the second partition wall member.

## Description

### TECHNICAL FIELD

The present invention relates to a method for manufacturing a substrate for a light-emitting device and a method for manufacturing a light-emitting device.

### BACKGROUND ART

There are various light-emitting devices with different light sources, and one of these light-emitting devices includes an organic electroluminescent element (hereinafter, sometimes referred to as an organic EL element). A light-emitting device that includes an organic EL element as a light source is used in a display device, for example. Such a display device includes an organic EL element as a light source for a pixel and is currently directed toward practical use. This display device includes many organic EL elements that work as a pixel, and these organic EL elements are arranged in proper alignment on a substrate. On the substrate, a partition wall is generally arranged for separating the organic EL elements, each of which is arranged in an area separated by the partition wall.

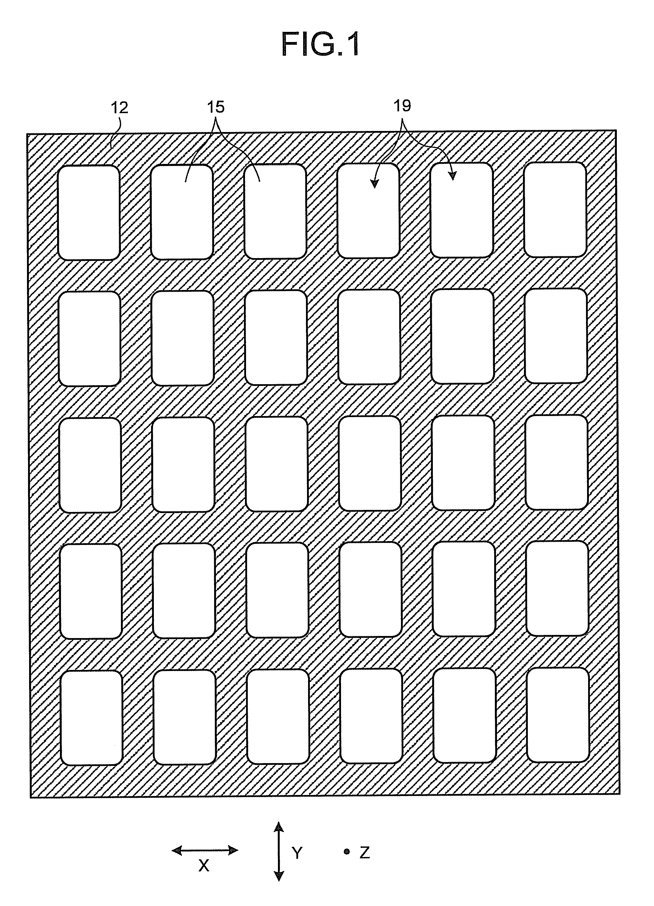

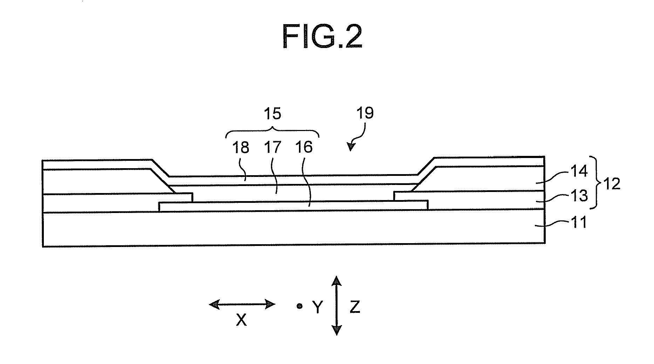

FIG. 1 is an enlarged plan view to schematically illustrate part of a light-emitting device that includes many organic EL elements 15 separated by a partition wall 12 that is provided on a substrate 11. FIG. 2 is an enlarged cross-sectional view to schematically illustrate a compartment in the light-emitting device in which the many organic EL elements 15 are separated by the partition wall 12. The plan view in FIG. 1 is a view that is viewed from a thickness direction Z of the substrate 11 (from the side of the partition wall). In the present specification, to be viewed from the thickness direction Z of the substrate 11 is occasionally also referred to as "in a planar view." A direction (a line direction of the grid-shape partition wall pattern illustrated in FIG. 1) that is perpendicular to the thickness direction Z is also referred to as a line direction X. As the same manner, a direction (a column direction of the grid-shape partition wall pattern illustrated in FIG. 1) that is perpendicular to both of the thickness direction Z and the line direction X is occasionally also referred to as a column direction Y.
FIG. 1 illustrates a light-emitting device in which the partition wall 12 having grid-shape is provided as an example. In FIG. 1, an area where the partition wall 12 is provided is illustrated with a hatch pattern. As illustrated in FIGS. 1 and 2, the organic EL element 15 is provided in an area 19 surrounded by the partition wall 12.

As illustrated in FIG. 2, the organic EL element 15 comprises a first electrode 16, a second electrode 18, and one or a plurality of organic EL layers 17 provided between the first electrode 16 and the second electrode 18. The first electrode corresponds to one of an anode and a cathode, while the second electrode corresponds to the other one of these electrodes that faces the first electrode. The substrate 11 generally has the first electrode 16 patterned thereon in advance. The partition wall 12 is formed on the substrate 11 on which the first electrode 16 is provided, and the first electrode 16 is exposed at the area 19 that is formed by the partition wall 12. The organic EL layer 17 can be formed on the first electrode 16 in the area 19 by a coating method, for example. By the coating method, an ink including a material of the organic EL layer 17 is supplied to the area 19 surrounded by the partition wall 12, and is then solidified, thereby forming the organic EL layer 17.

In the case of using a lyophilic component as the partition wall 12, the ink supplied to the area 19 surrounded by the partition wall 12 may move on the surface of the partition wall 12, and then overflow into the outside. Accordingly, in order to hold the ink within the area 19 surrounded by the partition wall 12, the partition wall 12 having lyophobicity to some extent is preferably used. On the other hand, in the case of using a partition wall that is lyophobic, the surface profile of the partition wall may affect the organic EL layer formation. For example, in the case where the ink is supplied to an area surrounded by the partition wall that is lyophobic, the ink dries and solidifies while being repelled by the surface of the partition wall, which may cause the organic EL layer to have a film thickness, at an area at the boundary between the organic EL layer and the partition wall, that is different from the film thickness in an area at the center. Therefore, in order to obtain an organic EL layer that is uniform in film thickness, the partition wall 12 having lyophilicity to some extent is preferably used. Thus, a partition wall that is lyophobic to some extent is required from the viewpoint of ink retention, while a partition wall that is lyophilic to some extent is required from the viewpoint of organic EL layer formation.

Accordingly, in conventional techniques, in order to simultaneously satisfy these two contradictory requirements for the partition wall 12, the partition wall 12 in which a first partition wall member 13 and a second partition wall member 14 that have different wettability to an ink are stacked on, as illustrated in FIG. 2, is used. That is, the partition wall 12 comprises the first partition wall member 13 having lyophilicity and the second partition wall member 14 having lyophobicity stacked on one another. In a planar view, the outer rim of the second partition wall member 14 in the area 19 is formed inwardly from the outer rim of the first partition wall member 13 so as to decrease the influence of the second partition wall member 14 that is lyophobic on the formation of the organic EL layer 17 in the area 19 at which the organic EL element 15 emits light (see Patent Document 1, for example).

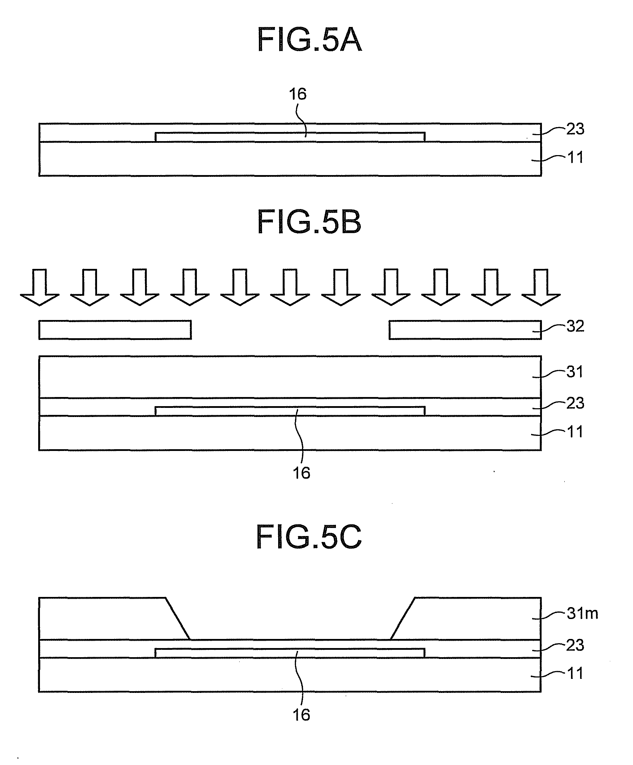

Next, a step of forming the first partition wall member 13 and the second partition wall member 14 each described above is explained. FIGS. 5A to 5F are each a schematic for explaining a step of forming the first partition wall member 13 and the second partition wall member 14.

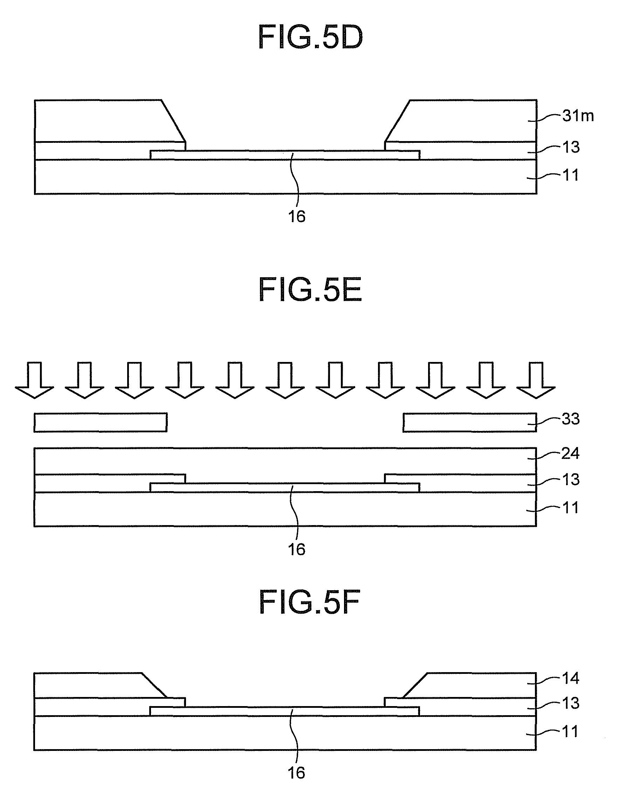

First, as illustrated in FIG. 5A, a first thin film 23 for forming the first partition wall member is formed all over the supporting substrate 11 on which the first electrode 16 is patterned. Then, as illustrated in FIG. 5B, a photosensitive resin film 31 (a positive photosensitive resin film is used in the figure) is formed on the first thin film 23. Exposure is then performed on a prescribed portion of the photosensitive resin film 31 through a photomask 32. Bold arrow symbols in FIGS. 5B and 5E schematically illustrate the direction of light travel. Subsequently, as illustrated in FIG. 5C, by development and post-baking of the photosensitive resin film 31, a mask 31m made of the photosensitive resin 31 is formed on the first thin film 23. Then, as illustrated in FIG. 5D, etching is performed through the mask 31m to remove a portion, of the surface of the first thin film 23, that undergoes exposure through the mask 31, thereby forming the first partition wall member 13. The mask 31m is then removed to proceed to a step of forming the second partition wall member 14. In the step of forming the second partition wall member 14, as illustrated in FIG. 5E, a photosensitive resin is first applied for film formation to all over the substrate 11 to form a second thin film 24 for forming the second partition wall member. Then, exposure is performed on a prescribed portion of the second thin film 24 through a photomask 33. The photomask 33 used in this step has an opening the width of which is larger than that of the photomask 32 used in the step illustrated in FIG. 5B. Then, by development and post-baking of the second thin film 24, the second partition wall member 14 is formed as illustrated in FIG. 5F.

### Citation List

### Patent Document

Patent Document 1: International Publication No. WO 99/48339

### Summary of Invention

### Problem to be solved by the Invention

Formation of the partition wall 12 that comprises the first partition wall member 13 and the second partition wall member 14 requires many steps, as described above. Therefore, it is required that the number of steps is decreased.

Thus, an object of the present invention is to provide a method for manufacturing a substrate for a light-emitting device, by which method a partition wall that comprises a first partition wall member and a second partition wall member can be formed in fewer steps.

### Means for solving the Problem

The present invention provides a method for manufacturing a substrate for a light-emitting device and a method for manufacturing a light-emitting device, which are described below.

[1] A method for manufacturing a substrate for a light-emitting device comprising a supporting substrate and a partition wall for separating a plurality of organic electroluminescent elements to be formed on the supporting substrate, wherein the partition wall comprises a first partition wall member formed on the supporting substrate and a second partition wall member formed on the first partition wall member, the method comprising:
forming a first thin film for forming the first partition wall member, on the supporting substrate;
forming a second thin film for forming the second partition wall member, on the first thin film by using a photosensitive resin;
removing a residual portion of the second thin film that is other than a portion overlapping with the first partition wall member to be formed, as viewed from a thickness direction of the supporting substrate, by using a photolithography method;
removing a residual portion of the first thin film that is other than a portion covered with the second thin film by using etching, thereby forming the first partition wall member; and
removing a surface part of the second thin film by etching, thereby forming the second partition wall member. [2] The method for manufacturing a substrate for a light-emitting device according to above [1], wherein a method of the etching for the surface part of the second thin film is ashing.
[3] The method for manufacturing a substrate for a light-emitting device according to above [1] or [2], further comprising a step of providing, after forming the second partition wall member, lyophobicity to a surface of the second partition wall member by a plasma-ion irradiation method in an atmosphere containing fluoride, wherein the first partition wall member is formed of an inorganic material.
[4] A method for manufacturing a light-emitting device, comprising:
   preparing a substrate for a light-emitting device that is made by using the method for manufacturing a substrate for a light-emitting device according to any of above [1] to [3]; and
   forming organic electroluminescent elements on the substrate for a light-emitting device.

### Effects of Invention

According to the present invention, a substrate for a light-emitting device including a partition wall that comprises a first partition wall member and a second partition wall member can be manufactured in fewer steps.

### Brief Description of Drawings

[FIG.1] FIG. 1 is an enlarged plan view to schematically illustrate part of a light-emitting device in which many organic EL elements 15 are provided.
[FIG.2] FIG. 2 is an enlarged cross-sectional view to schematically illustrate a compartment separated by a partition wall 12 in the light-emitting device.
[FIG.3A] FIG. 3A is a schematic for explaining a step of forming a first partition wall member 13 and a second partition wall member 14 on a substrate to obtain a substrate for a light-emitting device.
[FIG.3B] FIG. 3B is a schematic for explaining a step of forming the first partition wall member 13 and the second partition wall member 14 on the substrate to obtain the substrate for a light-emitting device.
[FIG.3C] FIG. 3C is a schematic for explaining a step of forming the first partition wall member 13 and the second partition wall member 14 on the substrate to obtain the substrate for a light-emitting device.
[FIG.3D] FIG. 3D is a schematic for explaining a step of forming the first partition wall member 13 and the second partition wall member 14 on the substrate to obtain the substrate for a light-emitting device.
[FIG.3E] FIG. 3E is a schematic for explaining a step of forming the first partition wall member 13 and the second partition wall member 14 on the substrate to obtain the substrate for a light-emitting device.
[FIG.3F] FIG. 3F is a schematic for explaining a step of forming the first partition wall member 13 and the second partition wall member 14 on the substrate to obtain the substrate for a light-emitting device.
[FIG.4A] FIG. 4A is a schematic for explaining a step of forming an organic EL element 15 on a substrate for a light-emitting device to obtain a light-emitting device.
[FIG.4B] FIG. 4B is a schematic for explaining a step of forming the organic EL element 15 on the substrate for a light-emitting device to obtain the light-emitting device.
[FIG.5A] FIG. 5A is a schematic for explaining a conventional step of forming a first partition wall member 13 and a second partition wall member 14.
[FIG.5B] FIG. 5B is a schematic for explaining a conventional step of forming a first partition wall member 13 and a second partition wall member 14.
[FIG.5C] FIG. 5C is a schematic for explaining a conventional step of forming a first partition wall member 13 and a second partition wall member 14.
[FIG.5D] FIG. 5D is a schematic for explaining a conventional step of forming a first partition wall member 13 and a second partition wall member 14.
[FIG.5E] FIG. 5E is a schematic for explaining a conventional step of forming a first partition wall member 13 and a second partition wall member 14.
[FIG.5F] FIG. 5F is a schematic for explaining a conventional step of forming a first partition wall member 13 and a second partition wall member 14.

### Description of Embodiments

An embodiment of the present invention will be described below. In the description below, a term "electroluminescent" in "organic electroluminescent layer" and "organic electroluminescent element" is sometimes abbreviated as EL.
A method for manufacturing a substrate for a light-emitting device of the present invention is a method for manufacturing a substrate for a light-emitting device in which a supporting substrate and a partition wall for separating a plurality of organic EL elements provided on the supporting substrate are provided, and the partition wall comprises a first partition wall member provided on the supporting substrate and a second partition wall member provided on the first partition wall member. The method comprises: forming a first thin film for forming the first partition wall member, on the supporting substrate; forming a second thin film for forming the second partition wall member, on the first thin film by using a photosensitive resin; removing a residual portion of the second thin film that is other than a portion overlapping with the first partition wall member to be formed, as viewed from a thickness direction of the supporting substrate, by using a photolithography method; removing a residual portion of the first thin film that is other than a portion covered with the second thin film by etching, thereby forming the first partition wall member; and removing a surface part of the second thin film by etching, thereby forming the second partition wall member. The present invention also relates to a method for manufacturing a light-emitting device, comprising forming an organic EL element on the substrate for a light-emitting device, thereby manufacturing a light-emitting device.

A light-emitting device that is obtained by the manufacturing method of the present invention is utilized in a display device, for example. Display devices are principally of an active matrix-driven type or a passive matrix-driven type. The light-emitting device that is obtained by the manufacturing method of the present invention can be applied to display devices of either type. The present embodiment describes a light-emitting device that is applied to an active matrix-driven display device as an example

### <Structure of Light-Emitting Device>

First, the structure of the light-emitting device is explained. The structure of the light-emitting device that is manufactured by the manufacturing method of the present embodiment is the same as that of a light-emitting device in a conventional technique illustrated in FIGS. 1 and 2. Therefore, the structure of the light-emitting device of the present embodiment is explained below referring to FIGS. 1 and 2. FIG. 1 is an enlarged plan view to schematically illustrate part of a light-emitting device in which many organic EL elements 15 are provided. FIG. 2 is an enlarged cross-sectional view to schematically illustrate a compartment separated by a partition wall 12 in the light-emitting device. FIG. 1 illustrates a light-emitting device in which a grid-shape partition wall 12 is provided as an example. In FIG. 1, an area where the partition wall 12 is provided is illustrated with a hatch pattern. As illustrated in FIGS. 1 and 2, the organic EL element 15 is provided in an area 19 surrounded by the partition wall 12.

The partition wall 12 is provided on a supporting substrate 11 on which a first electrode 16 is patterned. The partition wall 12 is formed so as to surround the first electrode 16. The partition wall 12 comprises a first partition wall member 13 and a second partition wall member 14 which are stacked on. In the present embodiment, as illustrated in FIG. 2, the supporting substrate 11 on which the first electrode 16 is patterned, the first partition wall member 13, and the second partition wall member 14 are stacked in this order. Hereinafter, when an explanation is made without particularly differentiating between the first partition wall member 13 and the second partition wall member 14, the first partition wall member 13 and the second partition wall member 14 are collectively called the partition wall 12.

The partition wall 12 in the present embodiment is provided in a grid-shape as viewed from a thickness direction Z of the supporting substrate 11 (as described above, also occasionally referred to as "in a planar view" in the present specification). That is, the partition wall 12 comprises a plurality of components extending in a line direction X and a plurality of components extending in a column direction Y. The components extending in the line direction X are arranged at prescribed intervals in the column direction Y, while the components extending in the column direction Y are arranged at prescribed intervals in the line direction X. The components extending in the line direction X and the components extending in the column direction Y cross each other at right angles and are formed in an integrated fashion. In other words, the partition wall 12 is a flat plate-shape component in which a plurality of openings 19 are formed in a matrix. That is, the partition wall 12 is formed with a plurality of openings arranged at prescribed intervals in the line direction X and at prescribed intervals in the column direction Y, and the area inside the opening corresponds to the area 19 surrounded by the partition wall 12. The line direction X and the column direction Y are directions that are perpendicular to each other and are each perpendicular to the thickness direction Z of the supporting substrate 11. The width of the above described components that constitute the partition wall 12 depends on the specification of the light-emitting device, simplicity of the manufacturing steps, and the like and is generally about 10 µm to 100 µm.

The first partition wall member 13 and the second partition wall member 14 are each provided in a grid-shape in a planar view as described above with the outer rims thereof are different from each other in a planar view. As illustrated in FIG. 2, the second partition wall member 14 is formed in a way that the outer rim thereof is formed on the first partition wall member 13 so as to pull back inwardly from the outer rim of the first partition wall member 13. In other words, the first partition wall member 13 is formed in a way that, in a planar view, the outer rim thereof extends off the outer rim of the second partition wall member 14 into the area 19.

The thickness of the first partition wall member 13 depends on the specification of the light-emitting device, simplicity of the manufacturing steps, and the like and is generally about 30 nm to 500 nm. The thickness of the second partition wall member 14 depends on the specification of the light-emitting device, simplicity of the manufacturing steps, and the like and is generally about 0.5 µm to 5 µm.

On the supporting substrate 11, the organic EL elements 15 are provided. Each organic EL element 15 is provided in the area 19 surrounded by the partition wall 12. The area 19 is the area inside each of the openings that is formed in the partition wall 12, and each organic EL element 15 is provided inside each of the openings (in the area 19). In the present embodiment in which the grid-shape partition wall 12 is provided, the organic EL elements 15 are arranged in a matrix-shape. That is, the organic EL elements 15 are each arranged at prescribed intervals in the line direction X and at prescribed intervals in the column direction Y. The size of the organic EL element 15 or the opening (the area 19) depends on the specification of the light-emitting device, simplicity of the manufacturing steps, and the like, and the widths of the organic EL element 15 or the opening 19 in the line direction X and in the column direction Y are each about 30 µm to 300 µm in a display device, for example.

As illustrated in FIG. 2, the organic EL element 15 includes the first electrode 16, a second electrode 18, and one or a plurality of organic EL layers 17 interposed between the first electrode 16 and the second electrode 18. The first electrode corresponds to one of an anode and a cathode, while the second electrode corresponds to the other one of these electrodes that faces the first electrode. The substrate 11 generally has the first electrode 16 patterned thereon in advance. The partition wall 12 is formed on the substrate 11 on which the first electrode 16 is provided, and the first electrode 16 is exposed at the area 19 that is formed by the partition wall 12. The organic EL layer 17 is formed on the first electrode 16 in the area 19. The organic EL layer 17 may comprise one layer or a plurality of layers stacked on one another. The organic EL element 15 includes at least one light-emitting layer as the organic EL layer.

In the present embodiment, a substrate of an active matrix-driven type is used, and therefore the first electrodes 16 as many as organic EL elements 15 are provided on the supporting substrate 11. The first electrodes 16 are arranged in a matrix in the same manner as in the case of the organic EL elements 15. That is, the first electrodes 16 are each arranged at prescribed intervals in the line direction X and at prescribed intervals in the column direction Y. The first electrode 16 is formed as a thin film of a nearly rectangular shape, a nearly elliptical shape, or the like in a planar view. The first electrode 16 is formed, in a planar view, principally in an area that is other than an area where the first partition wall member 13 is to be provided, while in the present embodiment, the periphery of the first electrode 16 is covered with the first partition wall member 13. In other words, the first partition wall member 13 of the present embodiment is formed so as to cover the periphery of the first electrode 16.

The organic EL layer 17 means all the layers in the organic EL element 15 that are interposed between the first electrode 16 and the second electrode 18. As the organic EL layer 17, at least a light-emitting layer is provided as described above, and a hole injection layer, a hole transport layer, an electron block layer, a hole block layer, an electron transport layer, an electron injection layer, and the like are also provided, where appropriate. The organic EL layer 17 is provided in the area 19 that is on the first electrode 16 and is surrounded by the partition wall 12. That is, the organic EL layer 17 is provided on the first electrode 16 and inside the opening of the partition wall 12.

In the present embodiment, the second electrode 18 is provided to serve as an electrode common to the organic EL elements 15. That is, the second electrode 18 is provided on the organic EL layer 17 as well as on the partition wall 12 to be continuously formed across the organic EL elements 15.

### <Method for Manufacturing Substrate for Light-Emitting Device and for Manufacturing Light-Emitting Device>

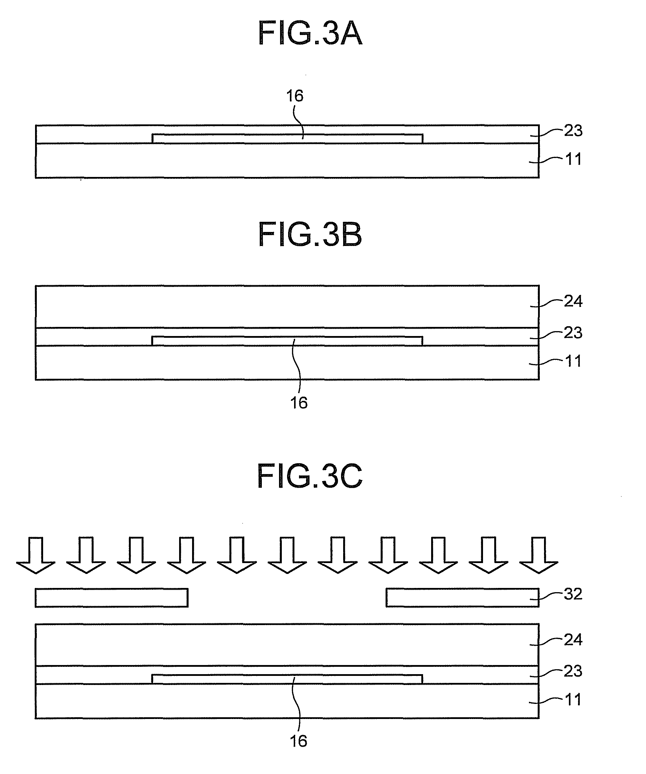

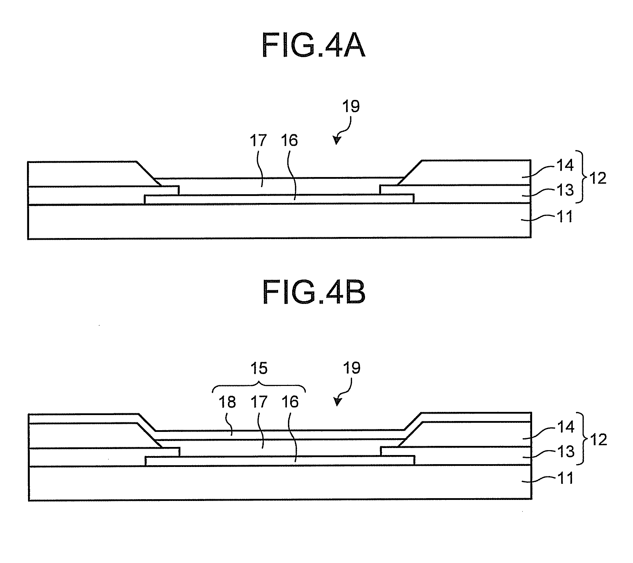

Next, referring to FIGS. 3A to 3F and FIGS. 4A and 4B, methods for manufacturing a substrate for a light-emitting device and for manufacturing a light-emitting device are explained. FIGS. 3A to 3F are each a schematic for explaining a step of forming the first partition wall member 13 and the second partition wall member 14, thereby obtaining a substrate for a light-emitting device. FIGS. 4A and 4B are each a schematic for explaining a step of forming the organic EL element 15 on the substrate for a light-emitting device, thereby obtaining a light-emitting device.

### (Step of Forming First Thin Film)

In this step, as illustrated in FIG. 3A, a first thin film 23 for forming a first partition wall member is formed on the supporting substrate 11 that includes the first electrode 16. The first thin film 23 for forming a first partition wall member means a thin film that is to be further processed in a later step into the first partition wall member 13.

The first partition wall member 13 and the second partition wall member 14 are made of components that are different from each other in wettability to ink. Alternatively, the first partition wall member 13 and the second partition wall member 14 may be formed of the same material, followed by lyophilic treatment or lyophobic treatment performed on one of these partition wall members to make wettability to ink of these partition wall members different from each other. In general, however, the first partition wall member 13 and the second partition wall member 14 are formed of different materials, thereby making wettability thereof different from each other. In the present embodiment, considering simplicity of steps, the magnitude of the difference in wettability, and the like, it is preferable that the first partition wall member 13 comprises an inorganic substance and the second partition wall member 14 comprises an organic substance. Because of this, in this step, a thin film made of an inorganic substance is formed as the first thin film 23.

In the present embodiment, the first thin film 23 is formed on the supporting substrate 11 on which the first electrode 16 is preformed. That is, the first thin film 23 is formed all over the supporting substrate 11 so as to cover the first electrodes 16. In the present embodiment, a substrate on which a circuit for individually driving a plurality of organic EL elements is preformed may be used as the supporting substrate 11 so as to make an active-matrix display device. For example, a substrate on which TFT (Thin Film Transistor) and the like are preformed may be used as the supporting substrate 11.

The first thin film 23 is made of an inorganic oxide or an inorganic nitride, for example. The first thin film 23 is made of SiOₓ or SiNₓ, for example.

The first thin film 23 is formed by a plasma CVD method, for example.

### (Step of Forming Second Thin Film)

In this step, as illustrated in FIG. 3B, a second thin film 24, of a photosensitive resin, for forming a second partition wall member is formed on the first thin film 23. The second thin film 24 for forming a second partition wall member means a thin film that is to be further processed in a later step into the second partition wall member 14. As described below, the second thin film 24 is utilized as a mask in etching of the first thin film 23, for example.

The second thin film 24 is made of an acrylic resin, a phenol resin, a polyimide resin, a novolac resin, or the like that is photosensitive to an actinic ray.

The second thin film 24 is formed on the first thin film 23 by a prescribed coating method. Examples of the coating method may include a spin coating method and a slit coating method.
Prior to exposure of the second thin film 24 to an actinic ray, pre-baking is generally performed on the second thin film 24. By pre-baking, a solvent contained in the second thin film 24 is evaporated.

### (Step of Patterning Second Thin Film by using a photolithography method)

In this step, as illustrated in FIG. 3C, a prescribed portion of the second thin film 24 is exposed to an actinic ray, followed by development. Through this process of exposure and development, a residual portion of the second thin film 24 that is other than a portion overlapping with the first partition wall member 13 to be formed is removed, as viewed from a thickness direction of the supporting substrate 11.

In this step where photolithography method is employed, the portion, of the second thin film 24, that undergoes exposure varies depending on the species of the photosensitive resin used in the second thin film 24. That is, the portion that undergoes exposure varies depending on which of a positive photosensitive resin or a negative photosensitive resin is used. In the present embodiment, the second thin film 24 is formed using a positive photosensitive resin, and therefore the portion of the second thin film 24 that is to be removed undergoes exposure in this step. Exposure is performed, for example, by irradiating the second thin film 24 with light (an actinic ray) through a photomask 32. In FIG. 3C, arrow symbols schematically illustrate the direction of light travel. In the present embodiment, light is applied to a residual area that is other than an area overlapping with, in a planar view, the first partition wall member 13 to be formed. As a light source in exposure, a KrF excimer laser, an ArF excimer laser, a high-pressure mercury lamp, or a metal halide lamp can be used, for example.

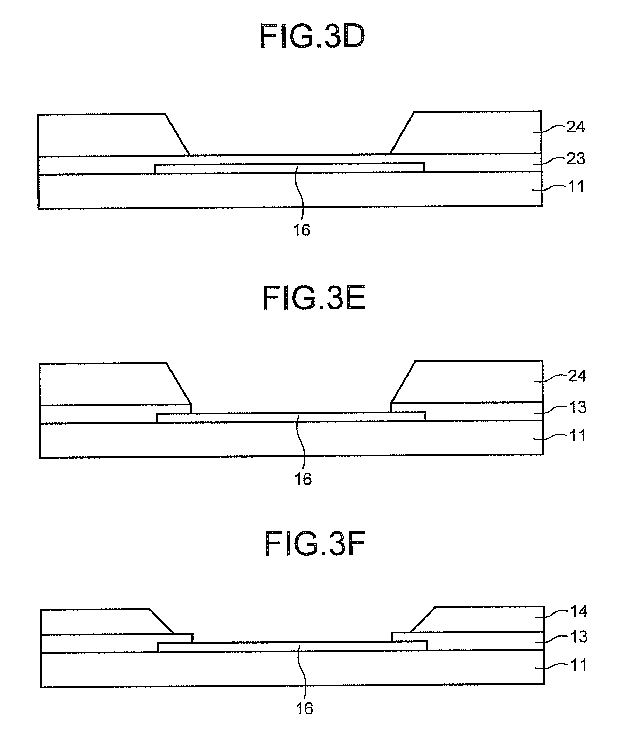

Following exposure, development of the second thin film 24 is performed as illustrated in FIG. 3D. Development is performed by a dipping method, a puddling method, or a spraying method, for example. As a developer solution, an aqueous TMAH (Tetra-methyl ammonium hydroxide) solution, or potassium hydroxide may be used, for example. Subsequently, rinsing is performed, where appropriate, thereby removing a residual portion of the second thin film 24 that is other than a portion where the first partition wall member 13 is to be formed, as viewed from a thickness direction of the supporting substrate 11. Thus, a portion of the first thin film 23 where the first partition wall member 13 is to be formed is covered with the second thin film 24, while a residual area that is other than a portion where the first partition wall member 13 is to be formed is exposed from the second thin film 24. The shape of the second thin film 24 is designed in consideration of the etching accuracy for the first thin film 23 to be described below or the other factor. For this reason, the shape of the second thin film 24 may not completely correspond, in a planar view, with the portion where the first partition wall member 13 is to be formed. That is, the second thin film 24 may be formed to have an area that substantially corresponds, in a planar view, with the portion where the first partition wall member 13 is to be formed.

### (Step of Forming First Partition Wall Member)

In this step, as illustrated in FIG. 3E, a residual portion of the first thin film 23 that is other than a portion covered with the second thin film 24 is removed by etching, thereby forming the first partition wall member 13.

Etching is performed, for example, by dry etching such as reactive ion etching, reactive ion beam etching, ion beam etching, reactive laser beam etching, and reactive gas etching, or wet etching. In the present embodiment, etching is performed by reactive ion etching using an etching gas such as CF₄, CHF₃, and C₄F₈, for example. By etching, an opening is formed in the first thin film 23, and therefore the grid-shape first partition wall member 13 is obtained.

### (Step of Forming Second Partition Wall Member)

In this step, as illustrated in FIG. 3F, a surface part of the second thin film 24 is removed by etching, thereby forming the second partition wall member 14. The outer rim of the second thin film 24 before etching in this step corresponds with the outer rim of the first partition wall member 13 as illustrated in FIG. 3E; however, after etching in this step, the outer rim of the second partition wall member 14 is pulled back inwardly from the first partition wall member 13 in a planar view. As a result, as described above, the outer rim of the first partition wall member 13 extends off the outer rim of the second partition wall member 14 toward the center of the area 19 in a planar view.

Etching in this step may be any etching method by which the surface part of the second thin film 24 can be removed. For example, the surface part of the second thin film 24 can be removed by ashing.

Ashing is broadly classified into photoexcitation ashing and plasma ashing, and in the present embodiment, the surface part of the second thin film 24 is preferably removed by plasma ashing using oxygen gas. By removing the surface part of the second thin film 24 in this way, the outer rim of the first partition wall member 13 and the outer rim of the second partition wall member 14 can have a prescribed space therebetween. The space between the outer rim of the first partition wall member 13 and the outer rim of the second partition wall member 14 is generally about 0.1 µm to 3 µm. The thickness of the surface part of the second thin film 24 to be removed depends on the space to be provided between the outer rim of the first partition wall member 13 and the outer rim of the second partition wall member 14 as well as the tapered shape of the outer rim of the second thin film 24, and is about 0.05 µm to 1.5 µm. The thickness of the surface part of the second thin film 24 to be removed in this step can be controlled by adjusting the duration of ashing, for example.

Ashing can be performed using a dry etching device. In the case of performing the above-described etching of the first thin film 23 using a dry etching device, for example, after etching of the first thin film 23, ashing can be performed continuously in the dry etching device without taking the supporting substrate out of the dry etching device so as to form the second partition wall member 14. That is, after forming the first partition wall member 13, the second partition wall member 14 can be formed without taking the supporting substrate out of the dry etching device.

### (Step of Imparting Lyophobicity to Second Partition Wall Member)

In the case where the first partition wall member 13 is made of an inorganic substance and the second partition wall member 14 is made of an organic substance as in the present embodiment, both lyophilic treatment and lyophobic treatment can be performed so as to impart lyophilicity to the first partition wall member 13 while imparting lyophobicity to the second partition wall member 14.

Lyophilic treatment is first performed, thereby imparting lyophilicity to the first partition wall member 13 made of an inorganic substance and the second partition wall member 14 made of an organic substance. Then, in the present embodiment, plasma treatment is performed in an atmosphere containing a fluoride, thereby imparting lyophobicity to the surface of the second partition wall member 14. The fluoride in this treatment is in a gas state, and examples of the fluoride that can be used may include CF₄, CHF₃, CH₂F₂, C₃F₈, C₄F₆, C₄F₈, and the like. By this plasma treatment, a fluorine atom is bonded to the surface of the second partition wall member 14, and therefore lyophobicity is imparted to the second partition wall member 14. The surface of an inorganic substance is less prone to be fluorinated compared to the surface of an organic substance, and therefore the first partition wall member 13 made of an inorganic substance remains lyophilic in spite of this plasma treatment performed thereto. As a result, the difference between the lyophilicity of the first partition wall member 13 and the lyophobicity of the second partition wall member 14 can be enhanced, and the second partition wall member 14 that is more lyophobic can be obtained.
By these steps, the substrate for a light-emitting device can be obtained.

### (Step of Forming Organic EL Element)

In this step, an organic EL element is formed on the substrate for a light-emitting device obtained in the above step. In the present embodiment, the first electrode 16 is preformed on the substrate 11, and therefore the organic EL layer 17 and the second electrode 18 are formed thereon to form the organic EL element 15 on the substrate, whereby a light-emitting device is obtained.

As described above, the organic EL layer 17 is formed by a coating method. That is, as illustrated in FIG. 4A, ink containing an organic EL material of the organic EL layer 17 is first selectively supplied to the area (opening 19) surrounded by the above-described partition wall 12. Then, the ink supplied is solidified, thereby forming the organic EL layer 17.

Examples of the method of selectively supplying the ink may include printing methods such as an ink jet printing method, a letterpress printing method, an intaglio printing method, and a nozzle coating method.

In the case of forming the layer to be common to all the organic EL elements, it may not be necessary to selectively supply the ink containing an organic EL material to the area surrounded by the partition wall 12. The layer that is common to all the organic EL elements may be formed by selectively supplying the ink to the area surrounded by the partition wall 12 by the printing method described above, or may be formed by applying the ink to all over the surface by a spin coating method, a capillary coating method, a dip-coating method, or the like and then solidifying the ink.

The organic EL layer 17 may comprise a plurality of layers as described above, and in this case, one, two, or more layers among these layers may be formed by a method that is different from a coating method, such as a vapor deposition method.

Next, as illustrated in FIG. 4B, the second electrode 18 is formed. In the present embodiment, the second electrode 18 is formed all over the substrate 11. That is, a conductive thin film is formed all over the surface, namely on the organic EL layer 17 and the partition wall 12. Thus, the second electrode 18 is continuously formed on all the organic EL elements 15 on the substrate 11.
By these steps, the light-emitting device is obtained.

As explained above, in the present embodiment, the second thin film 24 is utilized as a mask in etching of the first thin film 23, and the surface part of the second thin film 24 after utilized as a mask undergoes etching thereby forming the second partition wall member 14.

As explained in the section of background art, a mask is also formed in conventional arts to be used in etching of a first thin film 23, that is to say, this mask is a necessary component to form a first partition wall member 13. However, in conventional arts, a photoresist that serves as the mask is once removed, and photolithography including a plurality of steps is then performed, thereby forming a second partition wall member 14. In contrast to this, in the present embodiment, a step of removing a surface part of the second thin film 24 that had been utilized as a mask is additionally carried out so as to form a second partition wall member 14. That is, in the present embodiment, the first partition wall member 13 and the second partition wall member 14 are formed by carrying out, in addition to the steps that are necessary to form the first partition wall member 13, only one additional step of removing the surface part of the second thin film 24. By forming the partition wall 12 in this way, the steps that are necessary to form the partition wall 12 can be fewer than those in the conventional arts.

Furthermore, in a conventional technique in which a second partition wall member 14 is formed by photolithography, it is necessary, in terms of the steps, to take a supporting substrate out of a dry etching device after forming a first partition wall member 13, peel and clean a photoresist off, perform photolithography to form a second partition wall member, and then bring the supporting substrate into a dry etching device for performing lyophilic treatment and lyophobic treatment by plasma treatment. In contrast to this, in the present embodiment in which the second partition wall member 14 is formed by removing a surface part of the second thin film 24 after forming the first partition wall member 13, the surface part of the second thin film 24 can be removed, while being left in a dry etching device after the formation of the first partition wall member 13, by etching to form the second partition wall member 14, as described above, and surface treatment can also be continuously performed in the same dry etching device. Because of this, in the present embodiment, it is not necessary to take the supporting substrate out of a dry etching device after forming the first partition wall member 13, peel and clean a photoresist off, perform photolithography to form the second partition wall member, and bring the substrate into a dry etching device, whereby the work and manufacturing steps can be easier than these in the conventional arts.

### <Structure of Organic EL Element>

The organic EL element can have various layer structures, as described above. The layer structure of the organic EL element, the structure of each layer, and the method for forming each layer are explained below in further detail.

As described above, the organic EL element has the pair of electrodes composed of the anode and the cathode (the first electrode and the second electrode) and one or more organic EL layers interposed between the electrodes, and has at least one light-emitting layer as the one or more organic EL layers. The organic EL element may have a layer containing both an inorganic substance and an organic substance, an inorganic layer, and the like.
The organic substance that constitutes the organic layer may be a low molecular compound, a macromolecular compound, or a mixture of a low molecular compound and a macromolecular compound. The organic layer preferably contains a macromolecular compound. The organic layer preferably contains a macromolecular compound having a number average molecular weight of 10³ to 10⁸ in terms of polystyrene.

The organic EL layer interposed between the cathode and the light-emitting layer may be the electron injection layer, the electron transport layer, the hole block layer, or the like. In the case where both of the electron injection layer and the electron transport layer are interposed between the cathode and the light-emitting layer, the layer closer to the cathode is called the electron injection layer, while the layer closer to the light-emitting layer is called the electron transport layer. The organic EL layers interposed between the anode and the light-emitting layer may be the hole injection layer, the hole transport layer, the electron block layer, or the like. In the case where both of the hole injection layer and the hole transport layer are provided, the layer closer to the anode is called the hole injection layer, while the layer closer to light-emitting layer is called the hole transport layer.

Examples of layer structures applicable to the organic EL element in the present embodiment are described below.
a) anode / light-emitting layer / cathode
b) anode / hole injection layer / light-emitting layer /cathode
c) anode / hole injection layer / light-emitting layer /electron injection layer / cathode
d) anode / hole injection layer / light-emitting layer /electron transport layer / cathode
e) anode / hole injection layer / light-emitting layer /electron transport layer / electron injection layer /cathode
f) anode / hole transport layer / light-emitting layer /cathode
g) anode / hole transport layer / light-emitting layer /electron injection layer / cathode
h) anode / hole transport layer / light-emitting layer /electron transport layer / cathode
i) anode / hole transport layer / light-emitting layer /electron transport layer / electron injection layer /cathode
j) anode / hole injection layer / hole transport layer /light-emitting layer / cathode
k) anode / hole injection layer / hole transport layer /light-emitting layer / electron injection layer / cathode
l) anode / hole injection layer / hole transport layer /light-emitting layer / electron transport layer / cathode
m) anode / hole injection layer / hole transport layer /light-emitting layer / electron transport layer / electron injection layer / cathode
n) anode / light-emitting layer / electron injection layer / cathode
o) anode / light-emitting layer / electron transport layer / cathode
p) anode / light-emitting layer / electron transport layer / electron injection layer / cathode

(The "forward slash (/)" indicates that the layers across a slash (/) are adjacently stacked. The same applies hereinafter.)

The organic EL element in the present embodiment may also have two or more light-emitting layers. The structure of the organic EL element having two light-emitting layers may be a layer structure of q) below where a stacked body interposed between an anode and a cathode in any one of the layer structures a) to p) described above is indicated by a "structural unit A." The layer structures of the two (structural units A) may be the same or different from each other.

### q) anode / (structural unit A) / charge generation layer /(structural unit A) / cathode

The structure of the organic EL element having three or more light-emitting layers may be a layer structure of r) below where "(structural unit A) / charge generation layer" is indicated by a "structural unit B".

### r) anode / (structural unit B)x / (structural unit A) /cathode

In this structure, a symbol "x" is an integer of two or more, and (structural unit B)x is a stacked body in which the structural unit B is stacked x times. The layer structures of the "structural units B" may be the same or different from each other.

In this context, the charge generation layer is a layer generating holes and electrons when electric field is applied thereto. Examples of the charge generation layer include a thin film made of vanadium oxide, indium tin oxide (ITO), molybdenum oxide, or the like.

In the organic EL element, the anode out of the pair of electrodes composed of the anode and the cathode may be arranged at the supporting substrate closer to the supporting substrate than the cathode, or the cathode may be arranged at the supporting substrate closer to the supporting substrate than the anode. For example, in a) to r) described above, each layer may be stacked on the supporting substrate from the right to form the organic EL element, or each layer may be stacked on the supporting substrate from the left to form the organic EL element.

The order of the layers to be stacked, the number of the layers, and the thickness of each layer can be designed as appropriate in consideration of light-emitting efficiency and the element life.

Next, the material of each layer that constitutes the organic EL element and the method to form the layer is more specifically explained.

### <Anode>

In the structure of an organic EL element where light emitted by the light-emitting layer is output through the anode to the outside of the element, an electrode having light transparency is used as the anode. As the electrode having light transparency, a thin film of a metal oxide, a metal sulfide, a metal, or the like can be used, and those having high electric conductivity and high light transparency are preferably used. Specifically, a thin film made of indium oxide, zinc oxide, tin oxide, ITO, indium zinc oxide (abbreviation: IZO), gold, platinum, silver, copper, or the like is used. Among these, a thin film made of ITO, IZO, or tin oxide is preferably used.

Examples of the method for making the anode may include a vacuum deposition method, a sputtering method, an ion plating method, and a plating method.

The film thickness of the anode is appropriately designed in consideration of properties required, ease of the film formation step, and the like. The film thickness of the anode is, for example, 10 nm to 10 µm, is preferably 20 nm to 1 µm, and is further preferably 50 nm to 500 nm.

### <Cathode>

A preferred material of the cathode has a small work function, facilitates electron injection into the light-emitting layer, and has high electric conductivity. In the organic EL element in which light is extracted from the anode side, the material of the cathode preferably has high visible light reflectance because the cathode reflects the light output from the light-emitting layer to the anode side. For example, alkali metals, alkaline-earth metals, transition metals, Group 13 metals in the periodic table, and the like may be used in the cathode. Examples of the material of the cathode to be used may include: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more species of the above-described metals; alloys of one or more species of the above-described metals and one or more species from gold, silver, platinum, copper, manganese, titanium, cobalt, nickel, tungsten, and tin; and graphite and graphite intercalation compounds. Examples of the alloy may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. As the cathode, a transparent conductive electrode made of a conductive metal oxide, a conductive organic substance, or the like can be used. Specific examples of the conductive metal oxide may include indium oxide, zinc oxide, tin oxide, ITO, and IZO. Examples of the conductive organic substance may include polyaniline or derivatives thereof, and polythiophene or derivatives thereof. The cathode may be a stacked body in which two or more layers are stacked. The electron injection layer may be used as the cathode.

The film thickness of the cathode is appropriately designed in consideration of properties required, ease of the film formation step, and the like. The film thickness of the cathode is, for example, 10 nm to 10 µm, is preferably 20 nm to 1 µm, and is further preferably 50 nm to 500 nm.

Examples of the method for making the cathode may include a vacuum deposition method, a sputtering method, and a lamination method by which a metal thin film is thermocompression bonded.

### <Hole Injection Layer>

Examples of the hole injection material of the hole injection layer may include oxides such as vanadium oxide, molybdenum oxide, ruthenium oxide, and aluminum oxide; phenylamine compounds; starburst amine compounds; phthalocyanine compounds; amorphous carbon; polyaniline; and polythiophene derivatives.

The film thickness of the hole injection layer is appropriately designed in consideration of properties required, ease of the film formation step, and the like. The film thickness of the hole injection layer is, for example, 1 nm to 1 µm, is preferably 2 nm to 500 nm, and is further preferably 5 nm to 200 nm.

### <Hole Transport Layer>

Examples of the hole transport material of the hole transport layer may include polyvinylcarbazole or derivatives thereof, polysilane or derivatives thereof, polysiloxane derivatives having an aromatic amine on a side chain or the main chain, pyrazoline derivatives, arylamine derivatives, stilbene derivatives, triphenyldiamine derivatives, polyaniline or derivatives thereof, polythiophene or derivatives thereof, polyarylamines or derivatives thereof, polypyrrole or derivatives thereof, poly(p-phenylene vinylene) or derivatives thereof, or poly(2,5-thienylene vinylene) or derivatives thereof.

The film thickness of the hole transport layer is designed in consideration of properties required, ease of the film formation step, and the like. The film thickness of the hole transport layer is, for example, 1 nm to 1 µm, is preferably 2 nm to 500 nm, and is further preferably 5 nm to 200 nm.

### <Light-Emitting Layer>

In general, the light-emitting layer is mainly made of an organic substance that emits any one of fluorescence and phosphorescence or both, or of the organic substance and a dopant assisting the organic substance. The dopant is added in order to improve the light-emitting efficiency and change the emission wavelength, for example. The organic substance constituting the light-emitting layer may be a low molecular compound or a macromolecular compound, and in the case of forming the light-emitting layer by a coating method, the light-emitting layer preferably contains a macromolecular compound. The number average molecular weight of the macromolecular compound constituting the light-emitting layer is, for example, about 10³ to 10⁸ in terms of polystyrene. Examples of the light-emitting material of the light-emitting layer may include pigment materials, metal complex materials, polymer materials, and dopant materials to be described below.

### (Pigment Materials)

Examples of the pigment materials may include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal Complex Materials)

Examples of the metal complex materials may include metal complexes having, as a central metal, a rare-earth metal such as Tb, Eu, and Dy, Al, Zn, Be, Ir, Pt, or the like and having, as a ligand, a structure of oxadiazole, thiadiazole, phenylpyridine, phenylbenzimidazole, quinoline, or the like. Examples of the metal complexes may include metal complexes that emit light from the triplet excited state such as iridium complexes and platinum complexes; aluminum-quinolinol complexes; benzoquinolinol beryllium complexes; benzoxazolyl zinc complexes; benzothiazole zinc complexes; azomethyl zinc complexes; porphyrin zinc complexes; and phenanthroline europium complexes.

### (Polymer Materials)

Examples of the polymer materials may include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized materials of the pigment materials or the metal complex light-emitting materials described above.

The thickness of the light-emitting layer is generally about 2 nm to 200 nm.

### <Electron Transport Layer>

As the electron transport material of the electron transport layer, known electron transport materials can be used. Examples of the electron transport material may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinoline or derivatives thereof, polyquinoxaline or derivatives thereof, or polyfluorene or derivatives thereof.

The film thickness of the electron transport layer is appropriately designed in consideration of properties required, ease of the film formation step, and the like. The film thickness of the electron transport layer is, for example, 1 nm to 1 µm, is preferably 2 nm to 500 nm, and is further preferably 5 nm to 200 nm.

### <Electron Injection Layer>

As the material of the electron injection layer, an optimum material is selected as appropriate depending on the species of the light-emitting layer. Examples of the material of the electron injection layer may include: alkali metals; alkaline-earth metals; alloys that contain one or more species of alkali metals and alkaline-earth metals; oxides, halides, or carbonates of alkali metals or alkaline-earth metals; or a mixture of these substances. Examples of the alkali metals, the oxides, the halides, and the carbonates of alkali metals may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metals, the oxides, the halides, and the carbonates of alkaline-earth metals may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a stacked body in which two or more layers are stacked. Examples of the stacked body may include a stacked body of LiF and Ca.

The film thickness of the electron injection layer is preferably about 1 nm to 1 µm.

Each of the organic EL layers described above can be formed, for example, by the coating method described above, a vacuum deposition method, a lamination method, or the like.

In the coating method, the ink containing an organic EL material for each organic EL layer is applied for film formation, thereby forming the organic EL layer. The solvent in the ink that is used to form the organic EL layer is, for example, chlorinated compound solvents such as chloroform, methylene chloride, and dichloroethane, ether solvents such as tetrahydrofuran, aromatic hydrocarbon solvents such as toluene and xylene, ketone solvents such as acetone and methyl ethyl ketone, ester solvents such as ethyl acetate, butyl acetate, and ethyl cellosolve acetate, water, and the like.

### Explanations of Letters or Numerals

- 11: supporting substrate
- 12: partition wall
- 13: first partition wall member
- 14: second partition wall member
- 15: organic EL element
- 16: first electrode
- 17: organic EL layer
- 18: second electrode
- 19: area (inside an opening of a partition wall)
- 23: first thin film
- 24: second thin film
- 31: photosensitive resin film (mask)
- 32, 33: photomask

## Claims

1. A method for manufacturing a substrate for a light-emitting device comprising a supporting substrate and a partition wall for separating a plurality of organic electroluminescent elements to be formed on the supporting substrate, wherein the partition wall comprises a first partition wall member formed on the supporting substrate and a second partition wall member formed on the first partition wall member, the method comprising:
forming a first thin film for forming the first partition wall member, on the supporting substrate;
forming a second thin film for forming the second partition wall member, on the first thin film by using a photosensitive resin;
removing a residual portion of the second thin film that is other than a portion overlapping with the first partition wall member to be formed, as viewed from a thickness direction of the supporting substrate, by using a photolithography method;
removing a residual portion of the first thin film that is other than a portion covered with the second thin film by using etching, thereby forming the first partition wall member; and
removing a surface part of the second thin film by etching, thereby forming the second partition wall member.

2. The method for manufacturing a substrate for a light-emitting device according to claim 1, wherein a method of the etching for the surface part of the second thin film is ashing.

3. The method for manufacturing a substrate for a light-emitting device according to claim 1, further comprising a step of providing, after forming the second partition wall member, lyophobicity to a surface of the second partition wall member by a plasma-ion irradiation method in an atmosphere containing fluoride, wherein the first partition wall member is formed of an inorganic material.

4. A method for manufacturing a light-emitting device, comprising:
preparing a substrate for a light-emitting device that is made by using the method for manufacturing a substrate for a light-emitting device according to claim 1; and
forming organic electroluminescent elements on the substrate for a light-emitting device.
